# EUROPÄISCHE PATENTSCHRIFT

(11) **EP 0 787 224 B1**
(45) Veröffentlichungstag und Bekanntmachung des Hinweises auf die Patenterteilung: **16.09.1998**
(21) Anmeldenummer: 95935818.5
(22) Anmeldetag: 18.10.1995
(51) Int. Cl.: C23C 18/30, C23C 16/18

(54) **VERFAHREN ZUR ABSCHEIDUNG VON METALLSCHICHTEN**
PROCESS FOR SEPARATING METAL COATINGS
PROCEDE PERMETTANT DE DEPOSER DES COUCHES DE METAL

(30) Priorität: 18.10.1994 DE 4438791; 18.10.1994 DE 4438777; 09.10.1995 DE 19538531
(43) Veröffentlichungstag der Anmeldung: 06.08.1997
(73) Patentinhaber: ATOTECH Deutschland GmbH, 10553 Berlin (DE)
(72) Erfinder: MEYER, Heinrich, D-14109 Berlin (DE); SCHULZ, Ralf, D-13465 Berlin (DE)
(74) Vertreter: Effert, Bressel und Kollegen
(86) Internationale Anmeldenummer: DE9501501
(87) Internationale Veröffentlichungsnummer: WO9612051

(56) Entgegenhaltungen:
- EP-A- 0 321 734
- EP-A- 0 329 845

## Beschreibung

Die Erfindung betrifft ein Verfahren zur Abscheidung von Metallschichten auf Polyimidoberflächen sowie ein Verfahren zur Herstellung eines elektrischen Schaltungsträgers, herstellbar unter Anwendung des Verfahrens.

Polyimid wird in der Elektronikindustrie als Substratmaterial für die Herstellung von Leiterplatten, Hybridschaltungen, Halbleiterträgern (Chip Carrier, Multi-Chip-Modulen) und anderen Bauelementen eingesetzt. Dieses Material weist gegenüber herkömmlichen Materialien, wie beispielsweise Epoxidharzen, Vorteile auf. Beispielsweise ist dessen thermische Beständigkeit höher, so daß die Längenausdehnung des Materials bei thermischer Belastung geringer ist als bei herkömmlichen Materialien. Ferner verfügen Polyimidsubstrate über bessere elektrische Isolationswerte.

Für den Einsatz als Substratmaterial in Halbleiterträgern können Vorprodukte des Polyimids auf einen geeigneten Träger durch ein Spin-Coating-Verfahren in dünner Schicht aufgebracht und anschließend zu Polyimid umgesetzt werden. In die derart gebildeten Schichten können einfach und reproduzierbar feinste Löcher geätzt werden, die zur Verbindung mehrerer Metallisierungsebenen dienen.

Zur Herstellung von Polyimidlaminaten, beispielsweise für die Leiterplattenherstellung, werden meist mit Kupferfolien kaschierte Polyimidfolien verwendet. Aus den Kupferschichten werden die Leiterzüge meist durch Ätzprozesse gebildet. Hierzu werden Verfahrenstechniken eingesetzt, die in der Literatur vielfach beschrieben sind (beispielsweise im Handbuch der Leiterplattentechnik, Hrsg. G. Herrmann, Band 2, Eugen G. Leuze Verlag, Saulgau 1991). Derartige Verfahren sind zur Herstellung von Leiterplatten zwar grundsätzlich geeignet, jedoch liegt die Breite der feinsten mit derartigen Techniken reproduzierbar herstellbaren Leiterzüge im Bereich von etwa 75 - 100 µm.

Die Kupferfolien werden in herkömmlicher Weise durch Verkleben mit den Polyimidoberflächen verbunden. Jedoch erweicht die Kleberschicht bei thermischer Behandlung, beispielsweise beim Löten der Leiterplatten, und ist auch gegenüber den chemischen Bädern, die für die Metallisierung von Löchern in den Polyimidlaminaten eingesetzt werden, nicht ausreichend beständig.

Um die Kleberschichten zu vermeiden, wurde die dem Fachmann geläufige "cast-on"-Technik zur Herstellung kleberfreier Polyimidlaminate entwickelt, bei der flüssige Polyamidsäurelösung vor der Dehydratisierung und Cyclisierung zum Polyimid auf eine Kupferfolie aufgegossen wird. Nach der Bildung des Polyimids auf der Kupferfolie entsteht auf diese Weise ein haftfester Polymer/Metall-Verbund. Auch dieses Verfahren hat den Nachteil, daß nur relativ dicke, beispielsweise 17 µm dicke Kupferfolien verwendet werden können. Ferner ist dieses Material außerordentlich teuer, zum Beispiel das Handelsprodukt Espanex® von Nippon Steel Chemical Co. Ltd, Tokyo

Mit dünnen Kupferfolien beschichtete Polyimidlaminate wurden zwar hergestellt. Jedoch ist der Aufwand zur Herstellung dieser Laminate außerordentlich hoch, so daß deren Materialkosten auch beträchtlich sind. Die Handhabung der mit dünnen Kupferfolien beschichteten Laminate ist darüber hinaus problematisch, da die Kupferfolien sehr empfindlich gegen mechanische Einwirkung sind. Im Falle der "cast-on"-Technik können derartig dünne Kupferfolien überhaupt nicht eingesetzt werden, da sich das Laminat bei der Herstellung u.a.stark verwerfen würde.

Feinere Leiterzüge sind daher allenfalls dadurch erzeugbar, daß keine mit Kupferfolien an der Oberfläche versehenen Laminate als Ausgangsmaterialien verwendet werden. Die Leiterzüge werden in diesem Fall durch Metallabscheidung direkt auf den Oberflächen gebildet. Durch Sputtern oder Metallverdampfen bzw. mittels chemischer Methoden hergestellte kleberfreie Polyimidsubstrate haben sich bei der Leiterplattenherstellung bislang nicht durchsetzen können. Beispielsweise ist es zur Erzeugung einer ausreichenden Haftfestigkeit der Metallschichten auf Polyimid erforderlich, zunächst eine dünne Chromschicht aufzubringen, auf die dann die Kupferschichten abgeschieden werden, beispielsweise rasterartig vorgebohrtes Material der Firma Sheldahl. Chrom bereitet beim Ätzen jedoch Schwierigkeiten, so ist beispielsweise ein zusätzlicher Ätzprozeß erforderlich, weshalb die Anwendung von Chromschichten möglichst vermieden wird. Aus technischer Sicht wäre es daher besonders erwünscht, Schaltungsträger aus unbeschichteten Polyimidmaterial herzustellen. Die technische Realisierung ist in der Praxis jedoch nicht gelungen. Dafür gibt es folgende Gründe:

Insbesondere bei Anwendung chemischer Metallabscheidungsmethoden tritt der Nachteil der größeren Wasseraufnahme von Polyimid gegenüber anderen Polymeren in den Vordergrund. Es hat sich beispielsweise gezeigt, daß die Haftfestigkeit von ganzflächig auf Polyimidfolien stromlos und elektrolytisch abgeschiedenen Kupferschichten zur Polyimidoberfläche bei thermischer Behandlung, beispielsweise beim Löten, erheblich verringert oder gänzlich aufgehoben wird. Um das Auftreten von blasenförmigen Abhebungen bei der thermischen Behandlung zu vermeiden, wird generell vorgeschlagen, die beschichteten Polyimidfolien nach der Abscheidung zu tempern. Die Temperungsbehandlung allein reicht jedoch nicht aus, das Auftreten von Blasen zu verhindern, wenn beidseitig und ganzflächig mit Kupferschichten versehene Polyimidfolien einer thermischen Behandlung ausgesetzt werden. In diesem Fall kann die eingeschlossene Feuchtigkeit, die vom chemischen Metallisierungsprozeß herrührt, bei der Temperungsbehandlung nicht mehr entweichen, so daß Wasser bei der thermischen Behandlung explosionsartig aus der Polyimidfolie austritt und die Kupferbeschichtung von der Polyimidoberfläche abreißt.

Aus den vorgenannten Gründen wurden andere Verfahren zur haftfesten Metallisierung von Polyimidsubstraten entwickelt. Wegen der Anforderung, eine ausreichende Haftfestigkeit der abgeschiedenen Metallschichten auch während und nach einer thermischen Beanspruchung der Substrate zu erreichen, wurden Vakuumverfahren zur Metallisierung eingesetzt. Die Metallabscheidung durch Zersetzen flüchtiger Metallverbindungen mittels Glimmentladung stellt hierzu eine überlegene Verfahrensweise dar. In DE 35 10 982 A1 wird ein solches Verfahren zur Herstellung elektrisch leitender Strukturen auf Nichtleitern, beispielsweise Polyimidfolien, durch Abscheidung metallischer Filme auf den Nichtleiteroberflächen durch Zersetzung metallorganischer Verbindungen in einer Glimmentladungszone offenbart. Die abgeschiedenen Metallfilme dienen vorzugsweise als katalytisch aktive Keimschichten zur nachfolgenden stromlosen Metallisierung der Oberflächen.

Auch in DE 38 06 587 A1 wird ein Verfahren zur Herstellung metallischer Strukturen auf Polyimid durch Zersetzung metallorganischer Verbindungen in einer Glimmentladung beschrieben.

Weitere Metallisierungsverfahren mittels Glimmentladung und metallorganische Verbindungen werden in den Druckschriften DE 37 16 235 A1, DE 37 44 062 A1 und DE 38 28 211 C2 offenbart.

Um möglichst reine Metallschichten mit der Glimmentladungsmethode herzustellen, d.h. Metallschichten ohne nennenswerte Kohlenstoff- und Sauerstoffbeimengungen, wird vorgeschlagen, das Substrat während der Metallabscheidung auf eine möglichst hohe Temperatur aufzuheizen. Die kohlenstoffhaltigen Beimengungen rühren von den organischen Bestandteilen der bei der Abscheidung meist verwendeten flüchtigen metallorganischen Verbindungen her. Den Einfluß der Substrattemperatur auf den Kohlenstoffgehalt der mit der Glimmentladungsmethode abgeschiedenen Metallschichten ist beispielsweise in E. Feurer und H. Suhr, "Thin palladium films prepared by metal-organic plasma-enhanced chemical vapour deposition", Thin Solid Films, 157 (1988), 81, 84 dargestellt. Danach nimmt der Kohlenstoffgehalt mit steigender Substrattemperatur ab. Aus dieser Druckschrift ist auch erkennbar, daß die Palladiumschichten bei Raumtemperatur knapp 30 Gew.-% Kohlenstoff enthalten.

Enthält die Metallschicht einen zu großen Kohlenstoffgehalt durch ungenügende Zersetzung der Metallverbindungen in der Glimmentladung bzw. durch nicht ausreichende Desorption der nur teilweise zersetzten Ligandenverbindungen von den Substratoberflächen, so ist die Leitfähigkeit der abgeschiedenen Metallschichten relativ gering, und zudem ist deren katalytische Aktivität zum Starten einer stromlosen Metallabscheidung auf den Oberflächen nicht ausreichend, so daß leicht mit Oxiden verunreinigte Metallschichten stromlos gebildet werden oder die Abscheidung vollständig ausbleibt.

Für viele Anwendungszwecke ist eine Erhitzung der Substrate nicht erwünscht. Daher wurden Versuche unternommen, den Kohlenstoffgehalt der Metallschichten auf andere Weise zu senken. Beispielsweise wird in der vorgenannten Druckschrift von E. Feurer und H. Suhr vorgeschlagen, die abgeschiedenen Metallschichten nachträglich mit einem Sauerstoffplasma nachzubehandeln. Eine weitere Alternative besteht nach Versuchen dieser Autoren darin, das bei der Metallabscheidung üblicherweise als Trägergas verwendete Argon vollständig durch Sauerstoff zu ersetzen. Anstelle von Palladium wird dadurch Palladiumoxid abgeschieden, das durch eine nachfolgende Behandlung in einem Wasserstoffplasma wiederum zu metallischem Palladium reduziert werden kann. Diese Vorgehensweise ist jedoch sehr kompliziert und aufwendig. Außerdem zersetzen sich die metallorganischen Verbindungen bereits beim Hindurchleiten des Sauerstoffs durch das Vorratsgefäß, das diese Verbindungen enthält, so daß nur ein geringer Teil die Glimmentladungszone erreicht.

Mit den Metallabscheidungsverfahren mittels eines Glimmentladungsverfahrens ist es zwar möglich, haftfeste Metallschichten auf Polyimidoberflächen zu erzeugen, wenn auf dieser Metallschicht weitere Metallschichten aus stromlosen und elektrolytischen Metallisierungsbädern abgeschieden werden. Es hat sich jedoch herausgestellt, daß eine ausreichende Haftfestigkeit der abgeschiedenen Metallschichten auf der Polyimidoberfläche dann nicht gegeben ist, wenn das beschichtete Substrat nach der erforderlichen Temperungsbehandlung und vor oder während des Testversuches zur Bestimmung der Haftfestigkeit mit wäßrig-alkalischen Lösungen in Berührung kommt. Als wäßrig-alkalische Lösungen kommen beispielsweise die Entwicklungs- und Strip-Lösungen im Strukturierungsprozeß mit Photoresisten in Betracht, um Leiterstrukturen aus den ganzflächig abgeschiedenen Metallschichten zu bilden. Eine nachträgliche Temperungsbehandlung kann die durch Kontakt mit der wäßrig-alkalischen Lösung verursachte Verringerung der Haftfestigkeit nicht mehr rückgängig machen.

Der vorliegenden Erfindung liegt von daher das Problem zugrunde, die Nachteile des Standes der Technik zu vermeiden und ein Verfahren zu finden, mit dem es gelingt, sehr reine Metallschichten auf Polyimidoberflächen stromlos abzuscheiden, um insbesondere feinste Leiterzugstrukturen zu erzeugen, wobei die Haftfestigkeit der Metallschichten auf den Oberflächen durch nach deren Abscheidung erfolgendem Kontakt mit wäßrig-alkalischen Lösungen nicht beeinträchtigt wird, sowie ein Verfahren, mit dem zur Herstellung von elektrischen S-chaltungsträgern mit Polyimidoberflächen auch feinste, auf den Polyimidoberflächen fest haftende Leiterzugstrukturen erzeugt werden können.

Das Problem wird gelöst durch die Merkmale der Ansprüche 1 und 11. Bevorzugte Ausführungsformen sind in den Unteransprüchen angegeben.

Derartig die Haftfestigkeit erhaltende Metallschichten auf Substraten mit Polyimidoberflächen können in einem Verfahren mit foigenden wesentlichen Verfahrensschritten erzeugt werden:
a- Abscheiden einer ersten kohlenstoff- und sauerstoffarmen Metallschicht auf den Polyimidoberflächen durch Zersetzen flüchtiger Metallverbindungen mittels eines Glimmentladungsverfahrens in Gegenwart einer oxidierenden Gasmischung, enthaltend inerte Gase und Sauerstoff oder Sauerstoff enthaltende Verbindungen,
b- stromloses Abscheiden einer zweiten Metallschicht auf der ersten Metallschicht aus einem sauer oder neutral eingestellten Metallisierungsbad.

Die mittels Glimmentladung abgeschiedene erste Metallschicht besitzt ungewöhnliche Eigenschaften: Bei Einstellung entsprechender Abscheidungsparameter ist sie glatt und hochglänzend. Durch Reiben an der Oberfläche dieser Schichten kann jedoch ein Teil des Metallfilmes leicht entfernt werden. Dieser Anteil der Schicht weist eine geringere Haftfestigkeit zum Substratmaterial auf. Mittels hochaufgelöster Elektronenmikroskopie (Rasterelektronenmikroskopie, Transmissionselektronenmikroskopie) konnte festgestellt werden, daß die abgeschiedene Schicht ein relativ kompaktes Gefüge von kugelförmigen Partikeln aufweist, die offensichtlich auch untereinander nur geringe Bindungskräfte besitzen.

Durch Abscheiden der ersten Metallschicht in einer die Sauerstoff enthaltenden Verbindungen enthaltenden Gasatmosphäre und Abscheiden der zweiten Metallschicht aus einer sauren oder neutralen stromlosen Metallisierungslösung kann dieser obere lockere Anteil der ersten Metallschicht verfestigt werden. Dadurch wird ein Haftverbund zwischen den Metallschichten und der Polyimidoberfläche geschaffen, der auch beim Kontakt mit wäßrig-alkalischen Lösungen nicht mehr beeinträchtigt wird. Darüber hinaus nimmt das so metallisiert Polyimid bei der chemischen Abscheidung deutlich weniger Feuchtigkeit auf als bei den bekannten Verfahren, so daß nach der Behandlung auch weniger Hydroxylionen im Material zurückbleiben, die insbesondere bei thermischer Belastung des Substrats den Haftverbund durch Hydrolyse schwächen könnten.

Bei der Herstellung feinster Leiterzüge werden besondere Anforderungen an die Haftfestigkeit der Leiterzüge auf der Laminatoberfläche gestellt. Dies liegt daran, daß die Haftung zur Laminatoberfläche nur über eine äußerst geringe Auflagefläche der Leiterzüge erreicht werden kann. Daher muß die Haftfestigkeit in diesem Fall unter verschiedenen Betriebsbedingungen außerordentlich hoch sein. Die Behandlung mit korrosiven Lösungen oder gasförmigen Stoffen, die diesen Verbund von der Seite her angreifen, kann beispielsweise sehr leicht dazu führen, daß sich die unterseitigen Ränder der Leiterzüge keilförmig von der Laminatoberfläche abheben. Im Gegensatz zu breiten Leiterzügen wirken sich derartige keilförmige Delaminationen auf die Haftfestigkeit feiner Leiterzüge daher insgesamt stärker aus als auf die breiteren Leiterzüge.

Durch Bilden der ersten Metallschicht mittels eines Glimmentladungsverfahrens in Gegenwart von Sauerstoff oder Sauerstoff enthaltenden Verbindungen können katalytisch hochaktive Metallschichten erhalten werden, so daß darauf sehr reine Metallschichten stromlos abgeschieden werden können. Als Sauerstoff enthaltende Verbindung wird vorzugsweise Sauerstoff (O₂) eingesetzt. Anstelle von Sauerstoff können jedoch auch Stickoxide (N₂O/NOₓ)verwendet werden, die in der Glimmentladung zumindest intermediär atomaren Sauerstoff sowie das inerte Gas Stickstoff bilden.

Die oxidierende Gasmischung enthält neben den flüchtigen Metallverbindungen und den Sauerstoff enthaltenden Verbindungen inerte Gase, beispielsweise Stickstoff oder Edelgase. Als Edelgas wird aus Kostengründen üblicherweise Argon verwendet.

Durch das Oxidationsvermögen der Sauerstoff enthaltenden Verbindungen in der Gasmischung zur Metallabscheidung werden die Substratoberflächen nach einer eventuellen Reinigung und Funktionalisierung der Oberflächen auch während der Metallabscheidung weiter gereinigt, hier vorzugsweise von den durch die Glimmentladung entstehenden organischen Bruchstücken der metallorganischen Verbindungen, so daß eine erhöhte Haftfestigkeit der Metallschichten ermöglicht wird. Durch Verwendung einer Gasmischung, die zusätzlich inerte Trägergase enthält, kann ferner auch die Bildung von Metalloxidschichten weitgehend verhindert werden, deren elektrische Leitfähigkeit und katalytische Aktivität für die stromlose Metallabscheidung nicht ausreichend hoch wäre. Ferner wird auch verhindert, daß sich die metallorganischen Verbindungen bereits vor dem Einleiten in die Glimmentladungszone zersetzen, da als Trägergase für die Verbindungen nicht reiner Sauerstoff, sondern ein Gasgemisch mit den inerten Gasen verwendet wird, das über die meist flüssigen Metallverbindungen geleitet wird.

In einer besonders gut geeigneten Gasmischung zur Bildung weitgehend kohlenstoff- und sauerstofffreier Metallschichten wird das Verhältnis des Partialdruckes der Sauerstoff enthaltenden Verbindungen zu dem der inerten Gase in der Gasmischung auf einen Wert zwischen 2:1 und 1:8, vorzugsweise zwischen 1:3 und 1:4, eingestellt. Unter der Annahme, daß die Liganden in den metallorganischen Verbindungen durch Sauerstoff zu Kohlendioxid und Wasser oxidiert werden, wird bei Einstellung eines Partialdruckverhältnisses von 1:3 bis 1:4 ein unter dem theoretischen (stöchiometrischen) Verbrauch von Sauerstoff liegender Wert festgestellt. Beispielsweise werden bei Einstellung des Verhältnisses von 1:3 bei der Verdampfung von n-Allyl-n-cyclopentadienyl-Palladium-(II) bei 45 °C etwa 15 % bis 75 % der stöchiometrischen Sauerstoffmenge für die vollständige Oxidation der Liganden in der Verbindung verbraucht. Überraschenderweise werden trotz des relativ hohen Sauerstoffgehaltes der Gasmischung sauerstoffarme Metallschichten erzeugt. Dies ist auf die erwähnte Oxidation der Liganden und den Sauerstoffverbrauch dieser Reaktion zurückzuführen.

Der Gesamtdruck der Gasmischung im Reaktionsgefäß, in dem die Zersetzung der Metallverbindungen stattfindet, liegt vorzugsweise zwischen 1 Pa und 50 Pa.

Als flüchtige Metallverbindungen werden die nach dem Stand der Technik bekannten Verbindungen, beispielsweise Palladium-, Kupfer-, Gold- oder Platinverbindungen oder deren Mischungen, eingesetzt. Andere Metallverbindungen sind ebenfalls grundsätzlich einsetzbar, sofern die gebildete Metallschicht katalytisch für die nachfolgende stromlose Metallisierung ist. Als besonders gut geeignete Verbindungen haben sich Dimethyl-n-cyclopentadienyl-Platin, Dimethyl-Gold-acetylacetonat und insbesondere n-Ailyl-n-cyclopentadienyl-Palladium-(II) erwiesen. Die in den eingangs genannten Druckschriften angegebenen Abscheidungsbedingungen sind auf die Erzeugung der Metallschichten nach dem erfindungsgemäßen Verfahren entsprechend übertragbar.

Palladium hat sich als besonders vorteilhaft herausgestellt, da es durch Ätzen leicht entfernt und darauf problemlos eine weitere Metallschicht aus einem Kupferbad stromlos abgeschieden werden kann. Werden andere Metalle als Palladium , die nicht katalytisch aktiv sind, zur Abscheidung der ersten Metallschicht verwendet, so wird das Substrat vor der stromlosen Metallisierung in eine Aktivierungslösung, beispielsweise eine Palladiumchloridlösung, getaucht.

Durch Erzeugung einer dünnen Schicht von Palladium entstehen für die nachfolgende stromlose Metallabscheidung katalytisch wirkende Metallschichten, so daß eine weitere Aktivierung dieser Metallschichten, beispielsweise mit edelmetallhaltigen Lösungen, nicht erforderlich ist. Mit dem erfindungsgemäßen Verfahren werden kohlenstoff- und sauerstoffarme Metallschichten mit dem Glimmentladungsverfahren in einem Verfahrensschritt gebildet. Eine weitere Behandlung, beispielsweise in einer Glimmentladung in Gegenwart reduzierender Gase, wie Wasserstoff, ist nicht erforderlich.

Es werden vorzugsweise 0,01 µm bis 0,1 µm dicke Schichten abgeschieden. Bei Bildung dünnerer Schichten wird der chemische Angriff der chemischen Lösungen nachfolgender Behandlungsschritte auf die Polyimidoberflächen verstärkt, so daß keine ausreichende Haftung mehr erreicht werden kann. Die Abscheidung zu dicker Metallschichten bringt keinerlei Vorteile. Neben langen Prozeßzeiten und hohen Kostenkönnen bei der Bildung insbesondere feinster Leiterzugstrukturen Probleme entstehen. Außerdem sind insbesondere dickere Palladiumschichten schwierig ätzbar.

Können bei der Metallabscheidung mittels Glimmentladung Metallschichten mit ausreichend hoher elektrischer Leitfähigkeit zur direkten nachfolgenden elektrolytischen Metallisierung gebildet werden, so ist es auch möglich, andere Metallverbindungen zur Abscheidung der ersten Metallschicht zu verwenden, beispielsweise Molybdänverbindungen.

Für die stromlose Metallisierung haben sich Metallisierungsbäder mit einem pH-Wert zwischen 2 und 8, vorzugsweise zwischen 2 und 7, als am günstigsten erwiesen. Es kommen insbesondere Nickel-, Kupfer-, Kobalt-, Palladium- oder Legierungsbäder dieser Metalle in Betracht.

Besonders geeignet sind eine Nickel/Bor-Legierungsschicht als zweite Metallschicht, da diese zur Erzeugung der Metallstrukturen aus der ganzflächigen Metallschicht leicht geätzt werden kann.

In einer anderen bevorzugten Ausführungsform werden als zweite Metallschicht eine sehr dünne Palladiumschicht oder eine Nickel/Phosphor-Legierungsschicht mit einem Phosphorgehalt zwischen 3 und 5 Gew.-% Phosphor stromlos abgeschieden.

Zur Herstellung hochverdichteter elektrischer Schaltungsträger mit sehr feinen Leiterzugstrukturen müssen in dem meist als Laminat ausgebildeten nichtleitenden Substrat mit Polyimidoberflächen zunächst feinste Löcher gebildet werden. Hierzu wird vorzugsweise ein Verfahren mit den folgenden wesentlichen Verfahrensschritten eingesetzt:
a- Aufbringen einer Metallschicht auf mindestens eine Subtratoberfläche, beispielsweise durch Abscheiden einer Metallschicht zum Beispiel aus Aluminium als temporäre Ätzmaske, zum Beispiel durch Aufdampfen,
b- Strukturieren der Metallschicht mit einer Photomaskentechnik mittels folgender Verfahrensschritte:
   ba- Belegen der Metallschicht mit einer Photomaske, vorzugsweise mit einem flüssigen Positiv-Photoresist,
   bb- Belichten und Entwickeln der Photomaske, wobei die Photomaske beim Entwickeln in den Bereichen entfernt wird, in denen Löcher im Substrat vorgesehen sind,
   bc- Ätzen der Löcher in der Metallschicht
c- Ätzen der Löcher im Substrat und
d- Entfernen der Metallschicht.

Vor dem Verfahrensschritt c) oder zwischen den Verfahrensschritten c) und d) wird die Photomaskenschicht von dem Substrat wieder entfernt.

Es hat sich erwiesen, daß bei der Verwendung von dünnen Aluminiumschichten als Plasmaätzmaske das Ätzen der Löcher in der Metallschicht während der Entwicklung des Photoresistes simultan erfolgen kann. Der Einsatz dünn aufgetragener Flüssigresiste ermöglicht das simultane Strippen dieses Resistes während des Plasmaätzens als weitere Prozeßvereinfachung.

Anschließend werden auf den Substratoberflächen Leiterzüge, vorzugsweise mit Leiterzugbreiten und -abständen unter 100 µm, und auf den Lochwänden Metallflächen nach dem folgenden Verfahrensschema gebildet:
e- Vorbehandeln der Oberflächen und Lochwände mittels eines Glimmentladungsverfahrens mit einer oxidierenden Gasmischung, enthaltend eine Sauerstoff enthaltende Verbindung und gegebenfalls inerte Gase,
f- Abscheiden einer ersten Metallschicht durch Zersetzen flüchtiger Metallverbindungen mittels eines Glimmentladungsverfahrens in Gegenwart einer Gasmischung, enthaltend inerte Gase und Sauerstoff enthaltende Verbindungen, einer zweiten Metallschicht mittels stromloser Metallabscheidung aus einer sauren oder neutralen Metallisierungslösung sowie gegebenenfalls weiterer stromlos und/oder elektrolytisch abgeschiedener Metallschichten,
g- Strukturieren einzelner Metallschichten mittels einer Photomaskentechnik, vorzugsweise unter Verwendung einer positiven Photolackschicht.

Nachfolgend werden exemplarische Ausführungsformen der Erfindung beschrieben:

Als Polyimidsubstrate kommen verschiedene Materialien in Betracht: Neben Polyimidfolien als solchen können diese auch, verpreßt mit anderen Trägermaterialien, wie beispielsweise FR4-Material (Epoxidharz/Glasfaser) und Kupferfolien, in einem Schichtlaminat verwendet werden. Ferner können plattenförmige Polyimidsubstrate ebenso wie Spin-Coating-Schichten nach dem erfindungsgemäßen Verfahren metallisiert werden. Unter Polyimid ist hierbei auch solches Material zu verstehen, das aus gelöstem und/oder nachgehärtetem Polyimid erzeugt wird. Darüber hinaus können Polyimide mit unterschiedlicher chemischer Struktur eingesetzt werden. Bei KAPTON H, Warenzeichen der Firma DuPont de Nemours, Inc., Wilmington, Del., USA, handelt es sich beispielsweise um ein Kondensationspolymerisationsprodukt von Pyromellitsäuredianhydrid (PMDA) mit Diaminodiphenylether (DDE). UPILEX, Warenzeichen der Fa. UBE Industries, Tokio, Japan ist dagegen aus einem Kondensationsprodukt aus 3,4,3',4'-Biphenyl-tetracarbonsäuredianhydrid (BPDA) mit DDE (UPILEX-R) oder mit p-Phenylendiamin (PPD) (UPILEX-S) hergestellt.

Vor der Abscheidung der ersten Metallschicht mittels Glimmentladung werden gegebenenfalls Löcher in das Polyimidsubstrat gestanzt, gebohrt oder vorzugsweise geätzt.

Die Metallschicht, die zur Herstellung der Ätzmaske (Lochmaske) für die Erzeugung der Löcher auf die Polyimidoberflächen aufgebracht wird, wird nur temporär auf die Oberflächen aufgebracht, d.h. vor dem Erzeugen der Leiterzüge wird sie wieder vom Polyimid entfernt und dient nicht als Grund-Metallschicht für die Bildung der Leiterzüge. Es können die auch für die Leiterzugerzeugung geeigneten Metalle abgeschieden werden. Da die Ätzmaske von dem gelochten Substrat wieder entfernt wird und zur Bildung der Leiterzüge eine neue Metallschicht abgeschieden wird, kann sich eine mögliche Beeinträchtigung des Verbundes zwischen der Ätzmaske und der Substratoberfläche beim Ätzen der Löcher nicht nachteilig auf die Haftfestigkeit der später erzeugten Leiterzüge auswirken.

Die zur Erzeugung der Löcher gebildeten Lochmasken auf den Substratoberflächen werden auf photochemischem Wege mit Photomasken erzeugt. Durch bevorzugte Verwendung eines positiven Photolackes als Photomaske werden eine wesentlich höhere optische Auflösung und damit feinere Strukturen erreicht, da mit einem Photolack dünnere Schichten herstellbar sind (5 - 10 µm Dicke) als beispielsweise mit Trockenfilmen (30 - 50 µm Dicke der Photoresistschichten), so daß das beim Belichten in die Schicht einfallende Licht weniger gestreut wird. Wegen der geringeren Dicke der Photolackschicht haftet diese auch besser auf der Unterlage. Durch Anwendung positiver Resiste kann ferner eine positive Bildvorlage bei der Belichtung der Resistschicht verwendet werden, so daß sich Belichtungsfehler weniger stark auswirken. Es können auch elektrophoretisch abscheidbare Resiste verwendet werden.

Die Löcher im Substrat werden danach in einem Trockenätz-Verfahren gebildet. Das Glimmentladungsverfahren hat sich als besonders günstig erwiesen. Hierzu wird das Substrat mit den darauf befindlichen Lochmasken in einer geeigneten Vorrichtung mit einem Gas, beispielsweise Sauerstoff, bevorzugt mit einer Mischung aus Sauerstoff und Tetraflourmethan (CF₄), behandelt.

Durch Optimierung der Behandlungsparameter, beispielsweise der Gaszusammensetzung und des Gasdruckes sowie der Glimmentladungsleistung, Behandlungstemperatur und -zeit, entstehen ausreichend steile Lochwände ohne rückgeätzte Hinterschneidungen unter der Lochmaske, so daß sehr feine Löcher auch in dickeren Substraten gebildet werden können.

Nach der Bildung der Löcher wird die metallische Ätzmaske wieder entfernt. Danach wird das perforierte Substrat gereinigt, beispielsweise mit einer Netzmittel enthaltenden wäßrigen Lösung.

Anschließend können die zu beschichtenden Oberflächen mittels eines Glimmentladungsverfahrens vorbehandelt werden. Beispielsweise werden die Oberflächen angeätzt, gereinigt und/oder mit reaktiven Gruppen funktionalisiert, indem die Gase mit den chemischen Gruppen an der Polyimidoberfläche reagieren.

Für die Vorbehandlung wird das Substrat in einen normalen Plasmareaktor, beispielsweise in einen Parallelplattenreaktor eingebracht, der als Rohr- oder Tunnelreaktor ausgebildet ist. Die Glimmentladung zur Vorbehandlung kann sowohl mit Gleichstrom als auch mit Wechselstrom (Hochfrequenz im kHz- oder MHz-Bereich) erzeugt werden. Vorzugsweise werden die Oberflächen in Sauerstoff, einer Sauerstoff enthaltenden Verbindung, wie einem Stickoxid (N₂O/NOₓ), einem Sauerstoff/Argon- oder Sauerstoff/Stickstoff-Gemisch angeätzt.

Die erste Metallschicht, die auch katalytisch aktiv und haftungsvermittelnd wirkt, wird auf die derart vorbehandelten Oberflächen durch Zersetzen flüchtiger Metallverbindungen aufgebracht. Hierzu wird ein inertes Trägergas durch einen Vorratsbehälter, der die metallorganische Verbindung enthält, hindurchgeleitet. Das inerte Gas enthält zusätzlich Sauerstoff enthaltende Verbindungen, vorzugsweise Sauerstoff (O₂) oder Stickoxide (N₂O/NOₓ). Wird dem Trägergas zum Überführen des Dampfes der Metallverbindung aus dem Vorratsbehälter die Sauerstoff enthaltende Verbindung nicht zugemischt, so wird diese in den Plasmareaktor separat eingeleitet und gelangt auf diese Weise in die Glimmentladungszone. Weiterhin kann der Strom der oxidierenden Trägergasmischung in zwei Teilströme aufgeteilt werden, die zum einen den Vorratsbehälter durchströmen und zum anderen direkt in den Plasmareaktor gelangen. Eine direkte Einleitung des Dampfes der metallorganischen Verbindung in den Plasmareaktor ohne Trägergas ist auch möglich. Die oxidierende Gasmischung wird dann direkt in den Plasma- reaktor geleitet.

Der Kohlenstoff- und Sauerstoffgehalt der mittels Glimmentladung ab; geschiedenenen Metallschichten kann beispielsweise mittels ESCA (Electron Spectroscopy for Chemical Analysis ermittelt werden. Hierzu wird das beschichtete Substrat in eine Ultrahochvakuumkammer eingebracht und mit Röntgenstrahlen (Al-K_{α} - oder Mg-K_{α}-Linie) belichtet. Die obersten Atomlagen der Metallschicht werden durch die energiereiche Strahlung angeregt und ionisiert, so daß Elektronen aus dem Material austreten. Deren Energie wird gemessen, so daß eine elementspezifische quantitative Analyse der Zusammensetzung der Metallschicht möglich ist.

Palladium hat sich zur Beschichtung als besonders vorteilhaft herausgestellt. Hierbei entstehen für die nachfolgende stromlose Metallabscheidung katalytisch wirkende Metallschichten, so daß eine weitere Aktivierung dieser Metallschichten, beispielsweise mit edelmetallhaltigen Lösungen, meist nicht erforderlich ist.

Die Bedingungen für die Metallisierung entsprechen im wesentlichen denen bei der Vorbehandlung mittels Glimmentladung. Der Druck in der Behandlungskammer beträgt im allgemeinen 1 Pa bis 50 Pa. Meist wird eine nahe bei Raumtemperatur oder wenig darüber liegende Temperatur am Substrat durch Variation der elektrischen Leistung der Glimmentladung eingestellt. Auch eine Erwärmung des Substratträgers ist vorteilhaft.

Auf diese Grundmetallschicht kann die zweite Metallschicht, beispielsweise eine Palladium-, eine Nickel/Bor-Legierungs- oder Nickel/Phosphor-Legierungsschicht, durch stromlose Metallisierung aus einem sauren oder neutralen Bad aufgebracht werden. Es kommen jedoch auch die Metalle Gold und Kobalt oder deren Legierungen sowie reines Nikkel oder, Legierungen des Kobalts in Betracht. Zum volladditiven Metallaufbau wird bevorzugt Palladium stromlos abgeschieden, da die Metallqualität der derzeit bekannten schwach sauren chemisch reduktiven Kupferbäder nicht für alle technischen Anforderungen ausreicht.

Wird Palladium zur Erzeugung der Leiterzüge nach einer anderen Verfahrensweise als der Additiv-Technik, wie beispielsweise dem Semiadditiv-Verfahren, als zweite Metallschicht aufgebracht, muß darauf geachtet werden, daß diese Palladiumschicht nur in geringer Schichtdicke abgeschieden wird. Dies ist erforderlich, da Palladium schwieriger ätzbar ist als beispielsweise eine Nickel/Bor-Legierungsschicht und daher nur dann einfach von den Oberflächen entfernt werden kann, wenn das Ätzmittel die Schicht durch Poren durchdringen und die Palladiumschicht von unten her abheben kann.

Für das erfindungsgemäße Verfahren werden die folgenden wäßrigen stromlosen Metallisierungsbäder bevorzugt eingesetzt:

| 1. | Stromloses Nickelbad mit Hypophosphit als Reduktionsmittel zur Erzeugung von Nickel/Phosphor-Schichten: | |
|---|---|---|
| | Nickelsulfat (NiSO₄.5 H₂O) | 25-30 g/l |
| | Natriumhypophosphit | 30 g/l |
| | Citronensäure | 2 g/l |
| | Essigsäure | 5 g/l |
| | Aminoessigsäure | 10 g/l |
| | Blei als Bleiacetat | 2 mg/l |
| | pH-Wert | 6,2 |
| | Temperatur | 80-84 °C |

Die Nickel/Phosphor-Schicht enthält etwa 4 Gew.-% Phosphor.

Anstelle von Nickelsalzen können auch Kobaltsalze zur Abscheidung von Kobalt/Phosphor-Legierungsschichten oder eine Mischung von Nickel- mit Kobaltsalzen zur Abscheidung von Nickel/Kobalt/Phosphor-Schichten verwendet werden.

| 2. | Stromlose Nickelbäder mit Dimethylaminoboran als Reduktionsmittel zur Erzeugung von Nickel/Bor-Schichten: | |
|---|---|---|
| 2a. | Nickelsulfat (NiSO₄.5 H₂O) | 25 g/l |
| | Dimethylaminoboran | 4 g/l |
| | Natriumsuccinat | 25 g/l |
| | Natriumsulfat | 15 g/l |
| | pH-Wert | 5,0 |
| | Temperatur | 60 °C |
| | | |
| 2b. | Nickelsulfat (NiSO₄.5 H₂O) | 40 g/l |
| | Dimethylaminoboran | 1-6 g/l |
| | Natriumcitrat | 20 g/l |
| | Milchsäure (85 Gew.-%ig) | 10 g/l |
| | pH-Wert | 7,0 |
| | Temperatur | 40 °C |
| | | |
| 2c. | Nickelsulfat (NiSO₄.5 H₂O) | 50 g/l |
| | Dimethylaminoboran | 2,5 g/l |
| | Natriumcitrat | 25 g/l |
| | Milchsäure (85 Gew.-%ig) | 25 g/l |
| | Thiodiglykolsäure | 1,5 mg/l |
| | pH-Wert | 6-7 |
| | Temperatur | 40 °C |
| | | |

Es können auch Bäder mit Nickelchlorid oder Nickelacetat anstelle von Nickelsulfat verwendet werden. Als Reduktionsmittel ist auch Diethylaminoboran anstelle von Dimethyaminoboran geeignet.

| 3. | Stromlose Palladiumbäder mit Ameisensäure bzw. deren Derivaten als Reduktionsmittel: | |
|---|---|---|
| 3a. | Palladiumacetat | 0,05 Mol/l |
| | Ethylendiamin | 0,1 Mol/l |
| | Natriumformiat | 0,2 Mol/l |
| | Bernsteinsäure | 0,15 Mol/l |
| | pH-Wert (Einstellung mit Ameisensäure) | 5,5 |
| | Temperatur | 67 °C |
| | | |
| 3b. | Palladiumdichlorid | 0,5 Mol/l |
| | 2-Diethylaminoethylamin | 0,6 Mol/l |
| | Methansäureethylester | 0,3 Mol/l |
| | Kaliumdihydrogenphosphat | 0,2 Mol/l |
| | pH-Wert (Einstellung mit Ameisensäure) | 6,0 |
| | Temperatur | 70 °C |
| | | |
| 3c. | Palladiumacetat | 0,05 Mol/l |
| | 1,2-Bis(3-aminopropylamino)-ethan | 0,1 Mol/l |
| | Natriumformiat | 0,3 Mol/l |
| | Bernsteinsäure | 0,1 Mol/l |
| | pH-Wert (Einstellung mit Ameisensäure) | 5,9 |
| | Temperatur | 59 °C |

| 4. | Stromloses Kupferbad mit Hypophosphit als Reduktionsmittel: | |
|---|---|---|
| | | |
| 4a. | Kupferchlorid (CuCl₂.2 H₂O) | 0,06 Mol/l |
| | N-(Hydroxyethyl)-ethylendiamintriacetat Trinatriumsalz | 0,074 Mol/l |
| | Natriumdihydrogenhypophosphit (NaH₂PO₂.H₂O) | 0,34 Mol/l |
| | pH-Wert | 6 |
| | Temperatur | 65 °C |
| | | |
| 4b. | Kupfersulfat (CUSO₄.5 H₂O) | 0,04 Mol/l |
| | N-(Hydroxyethyl)-ethylendiamintriacetat Trinatriumsalz | 0,05 Mol/l |
| | Natriumdihydrogenhypophosphit (NaH₂PO₂.H₂O) | 0,34 Mol/l |
| | pH-Wert | 3 |
| | Temperatur | 68 °C |

Außer den genannten Bädern können auch weitere Badtypen oder Bäder zur Abscheidung anderer Metalle verwendet werden, wenn diese sauer oder neutral sind, d.h. einen pH-Wert unterhalb von etwa 8, vorzugsweise zwischen 2 und 7, aufweisen.

Die stromlosen Metallisierungsbäder sollten eine möglichst geringe Temperatur und/oder eine möglichst hohe Abscheidungsgeschwindigkeit aufweisen, da dadurch die Haftfestigkeit der Metallschichten weiter erhöht werden kann.

Auf die zweite Metallschicht können weitere Metallschichten aus stromlosen oder elektrolytischen Metallisierungsbädern niedergeschlagen werden. Wenn die zweite Metallschicht bereits eine ausreichende Schichtdicke aufweist, so daß sie porenfrei ist, können die darauf abgeschiedenen Metallschichten auch mit alkalischen Metallisierungsbädern erzeugt werden. Hierzu kommen grundsätzlich alle abscheidbaren Metalle in Frage. Es werden die üblichen stromlosen und elektrolytischen Bäder eingesetzt.

Die Substrate werden mit den wäßrigen Behandlungsbädern, beispielsweise beim stromlosen oder elektrolytischen Metallisieren, durch Eintauchen in die Behandlungslösungen, aber auch in sogenannten horizontalen Behandlungsanlagen, in denen die Behandlungslösungen durch Schwallen an die Substrate herangebracht werden, in Kontakt gebracht.

In den nachfolgenden Beispielen ist die Erfindung erläutert:

In allen Beispielen wurden die folgenden Bedingungen eingehalten: Reaktortyp: Parallelplattenreaktor, Hochfrequenzspannung an der Substratelektrode, Frequenz: 13,56 MHz, Substrattemperatur: 35 °C :

Beispiel 1 (Abscheidung von Palladium auf Kapton H- Folie):
1. Vorbehandeln mittels Glimmentladung:
   Gas: Sauerstoff
   Druck: 25 Pa,
   Gasfluß: 100 Standard-cm³/min,
   Leistungsdichte: 0,8W/cm²
   Behandlungszeit: 90 Sekunden,
2. Pd-Abscheiden mittels Glimmentladung:
   Metallorganische Verbindung: π-Allyl-π-cyclopentadienyl-Palladium-(II),
   Gas: Ar/O₂ in einer Mischung 3:1 (Volumenverhältnis),
   Druck: 10 Pa,
   Gasfluß: 25 Standard-cm³/min,
   Leistungsdichte: 0,5W/cm²
   Verdampfertemperatur: 45 °C.

Es wurden 300 mg (Δ 1,4 mMol) der metallorganischen Verbindung verdampft und in den Reaktor überführt. Hierzu wurden insgesamt 60 Standard-cm³ Sauerstoff in der Argon/Sauerstoff-Mischung verbraucht. In einem weiteren Versuch wurden 240 Standard-cm³ Sauerstoff verbraucht. In beiden Fällen wurden weitgehend kohlenstofffreie Palladiumschichten erhalten. Unter der Annahme, daß die Liganden der metallorganischen Verbindung durch Sauerstoff zu Kohlendioxid und Wasser oxidiert werden, würden im vorliegenden Fall 330 Standard-cm³ Sauerstoff erforderlich sein.

Zur Erzeugung der Leiterzüge können unterschiedliche Verfahrensalternativen zur Anwendung kommen:

Beispiel 2 ("Lift-Off"-Verfahren):
1. Beschichten einer perforierten KAPTON E-Folie mit flüssigem Photoresist, belichten, entwickeln in 1 Gew.-%iger Na₂CO₃-Lösung,
2. Vorbehandeln mittels Glimmentladung:
   Gas: Sauerstoff
   Druck: 25 Pa,
   Gasfluß: 100 Standard-cm³/min,
   Leistungsdichte: 0,8W/cm²
   Behandlungszeit: 90 Sekunden,
3. Pd-Abscheiden mittels Glimmentladung:
   Metallorganische Verbindung: π-Allyl-π-cyclopentadienyl-Palladium-(II),
   Gas: Ar/O₂ oder N₂/O₂, jeweils in einer Mischung 3:1,
   Druck: 10 Pa,
   Gasfluß: 25 Standard-cm³/min,
   Leistungsdichte: 0,5W/cm²
   Verdampfertemperatur: 45 °C,
   Behandlungszeit: 10-15 Minuten,
4. Gegebenenfalls stromlos Palladium in einem Bad mit Ameisensäure als Reduktionsmittel abscheiden:
   Temperatur: 70 °C,
   pH-Wert: 6,0,
   Behandlungszeit: 5-8 Minuten,
5. Photomaske in Aceton entfernen,
6. Leiterbahnaufbau mit stromloser Palladiumabscheidung wie Verfahrensschritt 4. bis zur gewünschten Schichtdicke.

Der Vorteil dieser Verfahrensweise besteht darin, daß an den Stellen, an denen keine Leiterzüge gebildet werden, lediglich das zur Erzeugung der Lochmaske verwendete Metall aufgebracht und später wieder entfernt wird. Es wird an diesen Stellen jedoch keine für die Leiterzugerzeugung verwendete Metallschicht durch Zersetzen der flüchtigen Metallverbindungen in der Glimmentladung abgeschieden. Daher können sich an diesen Stellen keine Metallkontaminationen an der Substratoberfläche bilden, so daß der Isolationswiderstand zwischen den Leiterzügen besonders hoch ist.

Die Grund-Metallschichten auf den Photomasken-Bereichen werden so dünn gewählt, beispielsweise etwa 0,1 µm, daß deren Entfernung zusammen mit den darunter liegenden Photomasken leicht gelingt, d.h. ohne daß einzelne Stellen der Polymerfilme auf den Substratoberflächen zurückbleiben. Zur Entfernung der Polymerfilme werden übliche chemische Lösungen verwendet.

Beispiel 3 (Volladditiv-Technik):
1. Vorbehandeln einer perforierten UPILEX S-Folie in der Glimmentladung:
   Gas: Sauerstoff
   Druck: 25 Pa,
   Gasfluß: 100 Standard-cm³/min,
   Leistungsdichte: 0,8W/cm²
   Behandlungszeit: 90 Sekunden,
2. Pd-Abscheiden in der Glimmentladung:
   Metallorganische Verbindung: π-Allyl-π-cyclopentadienyl-Palladium-(II),
   Gas: Ar/O₂ oder N₂/O₂, jeweils in einer Mischung 3:1,
   Druck: 10 Pa,
   Gasfluß: 25 Standard-cm³/min,
   Leistungsdichte: 0,5W/cm²
   Verdampfertemperatur: 45 °C,
   Behandlungszeit: 10-15 Minuten,
3. Beschichten der Folie mit Trockenfilmresist, belichten, entwickeln in 1 Gew.-%iger Na₂CO₃-Lösung,
4. Im Resistkanal volladditiv stromlos Palladium in einem Bad mit Ameisensäure als Reduktionsmittel abscheiden:
   Temperatur: 70 °C,
   pH-Wert: 6,0,
   Behandlungszeit je nach gewünschter Schichtdicke,
5. Trockenfilmresist in Aceton entfernen,
6. Palladium-Differenzätzen mit verdünnter HNO₃/HCl-Lösung.

Falls die Grund-Metallschicht bereits eine ausreichende Leitfähigkeit aufweist, kann die zweite Metallschicht in den Resistkanälen auf elektrolytischem Wege aufgebracht werden.

Beispiel 4 (Subtraktiv-Technik/Panel-Plating):
1. Vorbehandeln einer perforierten KAPTON H-Folie mittels Glimmentladung:
   Gas: Sauerstoff
   Druck: 25 Pa,
   Gasfluß: 100 Standard-cm³/min,
   Leistungsdichte: 0,8W/cm²
   Behandlungszeit: 90 Sekunden,
2. Pd-Abscheiden mittels Glimmentladung:
   Metallorganische Verbindung: π-Allyl-π-cyclopentadienyl-Palladium-(II),
   Gas: Ar/O₂ oder N₂/O₂, jeweils in einer Mischung 3:1,
   Druck: 10 Pa,
   Gasfluß: 25 Standard-cm³/min,
   Leistungsdichte: 0,5 W/cm²
   Verdampfertemperatur: 45 °C,
   Behandlungszeit: 10-15 Minuten,
3. Nickel/Bor aus einem schwach sauren Bad stromlos abscheiden mit Dimethylaminoboran als Reduktionsmittel:
   Temperatur: 40 °C,
   Behandlungszeit: 2 Minuten,
4. Elektrolytisch Kupfer in einem schwefelsauren Kupferbad abscheiden:
   Cupracid BL (Fa. Atotech Deutschland GmbH, Berlin, DE)
   Stromdichte: 2 A/dm²,
   Schichtdicke: 25 µm,
5. Beschichten der Folie mit Trockenfilmresist, belichten, entwickeln in 1 Gew.-%iger Na₂CO₃-Lösung,
6. Abätzen der Kupfer- und der Nickel/Bor-Schicht:
   Ätzlösung: CuCl₂/HCl mit 120 g/l Cu ges., 1,5 Gew.-% HCl, NaCl gesättigt, 40°C,
7. Abätzen der Palladiumschicht:
   Ätzlösung: 1 Teil HNO₃,konz.;3 Teile HCl,konz.; 4 Teile Wasser
   Raumtemperatur,
   Behandlungszeit: 15 Sekunden,
8. Trockenfilmresist in Aceton entfernen.

Beispiel 5 (Semiadditiv-Technik/Pattern-Plating mit Nickel/Bor- oder Kupferschicht als zweiter Metallschicht):
1. Vorbehandeln einer perforierten Polyimid-Platte mittels Glimmentladung:
   Gas: Sauerstoff
   Druck: 25 Pa,
   Gasfluß: 100 Standard-cm³/min,
   Leistungsdichte: 0,8W/cm²,
   Behandlungszeit: 90 Sekunden,
2. Pd-Abscheiden mittels Glimmentladung:
   Metallorganische Verbindung: π-Allyl-π-cyclopentadienyl-Palladium-(II),
   Gas: Ar/O₂ oder N₂/O₂, jeweils in einer Mischung 3:1,
   Druck: 10 Pa,
   Gasfluß: 25 Standard-cm³/min,
   Leistungsdichte: 0,5W/cm²
   Verdampfertemperatur: 45 °C,
   Behandlungszeit: 10-15 Minuten,
3. Stromlos Nickel/Bor aus einem Bad mit Dimethylaminoboran als Reduktionsmittel abscheiden:
   Temperatur: 40 °C,
   Behandlungszeit: 2 Minuten,
   alternativ: Kupfer aus einem schwach sauren oder neutralen stromlosen Kupferbad mit Hypophosphit als Reduktionsmittel abscheiden,
4. Beschichten der Folie mit Trockenfilmresist, belichten, entwickeln in 1 Gew.-%iger Na₂CO₃-Lösung,
5. Leiterbahnaufbau mittels elektrolytischer Kupferabscheidung (Schichtdicke: 25 µm),
6. Metallresistschicht abscheiden (beispielsweise Zinn),
7. Abätzen der Kupfer- bzw. der Nickel/Bor-Schicht:
   Ätzlösung: CuCl₂/HCl mit 120 g/l Cu ges., 1,5 Gew.-% HCl, NaCl gesättigt, 40°C,
8. Abätzen der Palladiumschicht:
   Ätzlösung: 1 Teil HNO₃,konz.; 3 Teile HCl,konz.; 4 Teile Wasser
   Raumtemperatur,
   Behandlungszeit: 15 Sekunden,
9. Trockenfilmresist in Aceton entfernen.

Werden anstelle der oxidierenden Gasmischung in den vorstehenden Beispielen in den Verfahrensschritten 2. jeweils nur inerte Gasmischungen ohne Sauerstoff verwendet, beispielsweise reiner Stickstoff oder reines Argon, so entstehen kohlenstoffhaltige Palladiumschichten bei der Abscheidung mittels Glimmentladung, jedoch in geringerer Ausbeute, bezogen auf die eingesetzte metallorganische Verbindung. Darüberhinaus zeigen diese Schichten eine geringere katalytische Aktivität und die Haftfestigkeit zur Substratoberfläche ist nicht ausreichend beständig gegenüber alkalischen Prozeßschritten.

In den Beispielen 2 bis 5 werden ausnahmslos haftfeste Metallschichten erhalten, die auch nach einer thermischen Behandlung, beispielsweise einem Lötverfahren, oder nach bzw. während einer Behandlung mit wäßrig-alkalischen Lösungen, wie beispielsweise einer Entwickler- oder Striplösung für einen Photoresistfilm, ihre Haftfestigkeit zur Polyimidoberfläche beibehalten.

Die Haftfestigkeit der Metallschichten auf der Substratoberfläche wird insbesondere durch eine Wärmebehandlung nach der Abscheidung der stromlos und elektrolytisch abgeschiedenen Metallschichten erhöht (beispielsweise einstündiges Tempern bei 120 °C).

Wird dagegen beispielsweise in Beispiel 5 (Semiadditiv-Technik/Pattern-Plating) anstelle des sauren stromlosen Kupferbades ein alkalisches stromloses Kupferbad verwendet, so werden zwar nach der Abscheidung und einer Temperungsbehandlung bei 150 °C auch haftfeste Kupferschichten auf der Polyimidfolie erhalten. Die Haftfestigkeit sinkt jedoch auf sehr kleine Werte (beispielsweise von 1,2 N/mm auf 0,4 N/mm im Schältestversuch), wenn die mit Kupferstrukturen versehene Polyimidfolie in eine wäßrig-alkalische Entwicklerlösung getaucht wird.

Anstelle von Argon kann in den vorgenannten Beispielen auch ein anderes Edelgas, beispielsweise Neon, verwendet werden, wobei dieselben Versuchsergebnisse erhalten werden.

Als Folien ausgebildete, nach dem erfindungsgemäßen Verfahren hergestellte Polyimidfolien mit Leiterzügen können in geeigneten Verfahren zu Stapeln miteinander verklebt werden. Eine doppelseitige oder Vier-Lagen-Schaltung kann auch auf einen beliebigen starren Träger, beispielsweise eine Keramik- oder FR4-Platte (beispielsweise auch Leiterplatte) oder einen Siliziumträger geklebt oder laminiert werden. Man kann auch zwei, vier oder mehr nach dem erfindungsgemäßen Verfahren hergestellte Mehrlagenschaltungen unter Verwendung einer unbeschichteten Polyimid-Zwischenlage aufeinanderkleben und das erhaltene Zwischenprodukt gegebenenfalls mechanisch bohren und auf herkömmliche Weise naßchemisch durchkontaktieren. Die Leiterzüge in den einzelnen Leiterzugebenen werden dann auf herkömmlichem Wege nach dem Bohren von Löchern durch den Stapel hindurch durch stromloses Metallisieren der Lochwände miteinander elektrisch verbunden.

## Patentansprüche

1. Verfahren zur Abscheidung von gegen wäßrig-alkalische Lösungen resistent haftenden Metallschichten auf Polyimidoberflächen, insbesondere zur Erzeugung feinster Leiterzugstrukturen, mit folgenden wesentlichen Verfahrensschritten:
a- Abscheiden einer ersten kohlenstoff- und sauerstoffarmen Metallschicht auf den Polyimidoberflächen durch Zersetzen flüchtiger Metallverbindungen mittels eines Glimmentladungsverfahrens in Gegenwart einer oxidierenden Gasmischung, enthaltend inerte Gase und Sauerstoff enthaltende Verbindungen,
b- stromloses Abscheiden einer zweiten Metallschicht auf der ersten Metallschicht aus einem sauer oder neutral eingestellten Metallisierungsbad.

2. Verfahren nach Anspruch 1, dadurch gekennzeichnet, daß inerte Gase, ausgewählt aus der Gruppe der Edelgase und Stickstoff, verwendet werden.

3. Verfahren nach einem der vorstehenden Ansprüche, dadurch gekennzeichnet, daß Sauerstoff (O₂) als Sauerstoff enthaltende Verbindung verwendet wird.

4. Verfahren nach einem der vorstehenden Ansprüche, dadurch gekennzeichnet, daß das Verhältnis des Partialdruckes der Sauerstoff enthaltenden Verbindungen zu dem der inerten Gase in der Gasmischung auf einen Wert zwischen 2:1 und 1:8, vorzugsweise zwischen 1:3 und 1:4, eingestellt wird.

5. Verfahren nach einem der vorstehenden Ansprüche, dadurch gekennzeichnet, daß der Gesamtdruck der Gasmischung auf einen Wert zwischen 1 Pa und 50 Pa eingestellt wird.

6. Verfahren nach einem der vorstehenden Ansprüche, dadurch gekennzeichnet, daß Palladiumverbindungen als flüchtige Metallverbindungen verwendet werden.

7. Verfahren nach einem der vorstehenden Ansprüche, dadurch gekennzeichnet, daß die erste Metallschicht in einer Dicke von 0,01 µm bis 0,1 µm abgeschieden wird.

8. Verfahren nach einem der vorstehenden Ansprüche, dadurch gekennzeichnet, daß der pH-Wert des Metallisierungsbades zur stromlosen Abscheidung zwischen 2 und 8, vorzugsweise zwischen 2 und 7, eingestellt wird.

9. Verfahren nach einem der vorstehenden Ansprüche, dadurch gekennzeichnet, daß zur stromlosen Metallisierung ein Nickel-, Kupfer-, Kobalt-, Palladium- oder Legierungsbad dieser Metalle eingesetzt wird.

10. Verfahren nach einem der vorstehenden Ansprüche, dadurch gekennzeichnet, daß als zweite Metallschicht eine Nickel/Bor-Legierungsschicht oder eine Nickel/Phosphor-Legierungsschicht mit einem Phosphorgehalt zwischen 3 und 5 Gew.-% Phosphor oder eine Palladiumschicht stromlos abgeschieden wird.

11. Verfahren zur Herstellung eines elektrischen Schaltungsträgers, umfassend ein elektrisch nichtleitendes Substrat mit Polyimidoberflächen, Leiterzüge mit Leiterzugbreiten und -abständen unter 100 µm sowie Löcher mit Durchmessern unter 100 µm, herstellbar mittels folgender wesentlicher Verfahrensschritte:
- Aufbringen einer Metallschicht auf mindestens eine Substratoberfläche,
- Strukturieren der Metallschicht mittels einer Photomaskentechnik,
- Ätzen der Löcher im Substrat mittels eines Vakuumätzverfahrens,
- Entfernen der Metallschicht,
- Vorbehandeln der Oberflächen und Lochwände mittels eines Glimmentladungsverfahrens mit einer oxidierenden Gasmischung, enthaltend eine Sauerstoff enthaltende Verbindung,
- Abscheiden von Metallschichten durch
a- Abscheiden einer ersten kohlenstoff- und sauerstoffarmen Metallschicht auf den Polyimidoberflächen durch Zersetzen flüchtiger Metallverbindungen mittels eines Glimmentladungsverfahrens in Gegenwart einer oxidierenden Gasmischung, enthaltend inerte Gase und Sauerstoff enthaltende Verbindungen,
b- stromloses Abscheiden einer zweiten Metallschicht auf der ersten Metallschicht aus einem sauer oder neutral eingestellten Metallisierungsbad und
- Strukturieren einzelner Metallschichten mittels einer Photomaskentechnik.

## Claims

1. Method of depositing metal layers, which adhere resistantly to aqueous-alkaline solutions, on polyimide surfaces, more especially to produce very fine conductor track structures, having the following essential method steps:
a- depositing a first metal layer, which is low in carbon and oxygen, on the polyimide surfaces by decomposing volatile metal compounds by means of a glow-discharge method in the presence of an oxidising gas mixture, containing compounds which contain inert gases and oxygen, and
b- electrolessly depositing a second metal layer on the first metal layer from an acid- or neutral-set metallisation bath.

2. Method according to claim 1, characterised in that inert gases, selected from the group of noble gases and nitrogen, are employed.

3. Method according to one of the preceding claims, characterised in that oxygen (O₂) is employed as the oxygen-containing compound.

4. Method according to one of the preceding claims, characterised in that the ratio between the partial pressure of the oxygen-containing compounds and that of the inert gases in the gas mixture is set to a value between 2:1 and 1:8, preferably between 1:3 and 1:4.

5. Method according to one of the preceding claims, characterised in that the total pressure of the gas mixture is set to a value between 1 Pa and 50 Pa.

6. Method according to one of the preceding claims, characterised in that palladium compounds are employed as volatile metal compounds.

7. Method according to one of the preceding claims, characterised in that the first metal layer is deposited in a thickness of between 0.01 µm and 0.1 µm.

8. Method according to one of the preceding claims, characterised in that the pH value of the metallisation bath for the electroless deposition is set between 2 and 8, preferably between 2 and 7.

9. Method according to one of the preceding claims, characterised in that a nickel, copper, cobalt, palladium or alloy bath of these metals is used for the electroless metallisation.

10. Method according to one of the preceding claims, characterised in that a nickel/boron alloy layer or a nickel/phosphorus alloy layer having a phosphorus content between 3 and 5 % by wt. phosphorus or a palladium layer is electrolessly deposited as the second metal layer.

11. Method of producing an electric circuit carrier, which comprises an electrically non-conductive substrate with polyimide surfaces, conductor tracks with conductor track widths and spacings less than 100 µm and holes with diameters less than 100 µm, and which can be produced by means of the following essential method steps:
- applying a metal layer to at least one substrate surface,
- structuring the metal layer by means of a photomasking technique,
- etching the holes in the substrate by means of a vacuum etching method,
- removing the metal layer,
- pretreating the surfaces and hole walls by means of a glow-discharge method with an oxidising gas mixture, containing an oxygen-containing compound,
- depositing metal layers by
a- depositing a first metal layer, which is low in carbon and oxygen, on the polyimide surfaces by decomposing volatile metal compounds by means of a glow-discharge method in the presence of an oxidising gas mixture, containing compounds which contain inert gases and oxygen, and
b- electrolessly depositing a second metal layer on the first metal layer from an acid- or neutral-set metallisation bath, and
- structuring individual metal layers by means of a photomasking technique.

## Revendications

1. Procédé de dépôt de couches de métal adhérentes résistant à des solutions aqueuses alcalines sur des surfaces en polyimide, en particulier afin de produire des structures à pistes conductrices ultrafines, comprenant les étapes de procédé essentielles suivantes :
a) dépôt d'une première couche de métal pauvre en carbone et en oxygène sur les surfaces en polyimide par décomposition de composés métalliques volatils au moyen d'un procédé à effet corona en présence d'un mélange gazeux oxydant contenant des gaz inertes et des composés contenant de l'oxygène,
b) dépôt autocatalytique d'une deuxième couche de métal sur la première couche de métal à partir d'un bain de métallisation ajusté à un pH acide ou neutre.

2. Procédé selon la revendication 1, caractérisé en ce que les gaz inertes utilisés sont choisis dans le groupe comprenant les gaz rares et l'azote.

3. Procédé selon l'une au moins des revendications précédentes, caractérisé en ce que le composé contenant de l'oxygène utilisé est l'oxygène (O₂).

4. Procédé selon l'une au moins des revendications précédentes, caractérisé en ce que le rapport de la pression partielle des composés contenant de l'oxygène sur celle des gaz inertes dans le mélange gazeux est ajusté à une valeur comprise entre 2/1 et 1/8, de préférence entre 1/3 et 1/4.

5. Procédé selon l'une au moins des revendications précédentes, caractérisé en ce que la pression totale du mélange gazeux est ajustée à une valeur comprise entre 1 Pa et 50 Pa.

6. Procédé selon l'une au moins des revendications précédentes, caractérisé en ce que les composés métalliques volatils utilisés sont des composés de palladium.

7. Procédé selon l'une au moins des revendications précédentes, caractérisé en ce que la première couche de métal est déposée à une épaisseur comprise entre 0,01 µm et 0,1 µm.

8. Procédé selon l'une au moins des revendications précédentes, caractérisé en ce que le pH du bain de métallisation utilisé pour le dépôt autocatalytique est ajusté entre 2 et 8, de préférence entre 2 et 7.

9. Procédé selon l'une au moins des revendications précédentes, caractérisé en ce que l'on utilise pour le dépôt autocatalytique un bain de nickel, de cuivre, de cobalt, de palladium ou d'un alliage de ces métaux.

10. Procédé selon l'une au moins des revendications précédentes, caractérisé en ce que la deuxième couche de métal déposée par voie autocatalytique est une couche d'un alliage de nickel et de bore, une couche d'un alliage de nickel et de phosphore avec une teneur en phosphore comprise entre 3 et 5 % en poids, ou une couche de palladium.

11. Procédé de réalisation d'un support de circuit électrique comprenant un substrat électriquement non conducteur avec des surfaces en polyimide, des pistes conductrices avec une largeur de trait et des distances entre pistes inférieures à 100 µm ainsi que des trous de diamètre inférieur à 100 µm, et pouvant être obtenu par les étapes de procédés essentielles suivantes :
- dépôt d'une couche de métal sur au moins une surface du substrat,
- structuration de la couche de métal au moyen d'une technique utilisant des photomasques,
- gravure des trous dans le substrat au moyen d'un procédé de gravure sous vide,
- élimination de la couche de métal,
- prétraitement des surfaces et des parois des trous au moyen d'un procédé à effet corona avec un mélange gazeux oxydant contenant un composé qui contient de l'oxygène,
- dépôt de couches de métal par :
a) dépôt d'une première couche de métal pauvre en carbone et en oxygène sur les surfaces en polyimide par décomposition de composés métalliques volatils au moyen d'un procédé à effet corona en présence d'un mélange gazeux oxydant contenant des gaz inertes et des composés contenant de l'oxygène,
b) dépôt autocatalytique d'une deuxième couche de métal sur la première couche de métal à partir d'un bain de métallisation ajusté à un pH acide ou neutre, et
- structuration de couches de métal individuelles au moyen d'une technique utilisant des photomasques.
